# EUROPEAN PATENT APPLICATION

(11) **EP 4 212 958 A1**
(43) Date of publication of application: **19.07.2023**
(21) Application number: 21866995.0
(22) Date of filing: 04.08.2021
(51) Int. Cl.: G03F 7/004, H01L 21/027

(54) **PROCESS SOLUTION COMPOSITION FOR EXTREME ULTRAVIOLET PHOTOLITHOGRAPHY AND PATTERN FORMING METHOD USING SAME**

(30) Priority: 11.09.2020 KR 20200116967
(71) Applicant: Young Chang Chemical Co., Ltd., Seongju-gun, Gyeongsangbuk-do 40046 (KR)
(72) Inventor: LEE, Su Jin, Daegu 42634 (KR); KIM, Gi Hong, Daegu 41808 (KR); LEE, Seung Hun, Dalseong-gun Daegu 42918 (KR); LEE, Seung Hyun, Daegu 42747 (KR)
(74) Representative: Ter Meer Steinmeister & Partner
(86) International application number: PCT/KR2021/010199
(87) International publication number: WO 2022/055128

(57) **Abstract**

The present disclosure relates to a process solution composition for EUV photolithography and a pattern forming method using same. The process solution composition includes 0.00001% to 0.01% by weight of a fluorine-based surfactant, 0.00001% to less than 0.01% by weight of a pattern reinforcing agent represented by Formula (1), and 0.00001% to 0.001% by weight of a material selected from the group consisting of triol derivatives, tetraol derivatives, and mixture thereof, and the balance being water.

## Description

### Technical Field

The present disclosure relates to a process solution composition for reducing lifting defects on a photoresist pattern in photolithography using extreme ultraviolet light as an exposure source and to a photoresist pattern forming method using same.

### Background Art

Generally, a semiconductor device is manufactured using a lithographic process in which exposure light is infrared light with a wavelength of 193 nm, 248 nm, 365 nm, or the like. There is intense competition among semiconductor device manufacturers for reduction in a critical dimension (hereinafter referred to as a CD).

Accordingly, a light source for creating a shorter wavelength is required to form a finer pattern. At the present, a lithographic technology using extreme ultraviolet rays (EUV rays with a wavelength of 13.5 nm) is actively used. A finer pattern may be realized using this lithographic technology.

However, the resistance of an EUV photoresist to etching is not yet sufficiently improved, and thus a photoresist pattern with a high aspect ratio still needs to be used. Accordingly, pattern lifting defects easily occur during the development of a photoresist pattern. Consequently, a process margin is greatly reduced in manufacturing processes.

To solve this problem, there is a need for development of a technique capable of reducing lifting defects generated during the formation of fine patterns. The best way to reduce a pattern lifting defect level may be improving photoresist performance. However, a current status must be considered in which it is actually difficult to develop a novel high-performance photoresist that is satisfactory in terms of all aspects.

Aside from the development of a novel photoresist, attempts also have been made to lower the pattern lifting defect level for existing photoresists.

### Disclosure

### Technical Problem

The objective of the present disclosure is to provide a process solution composition capable of reducing pattern lifting defects remaining after a photoresist development process and a method of forming a photoresist pattern using the same.

### Technical Solution

A variety of surfactants have been used in a water-based process solution composition for use in a development process. Among them, an effective process solution composition proposed according to the present disclosure uses a fluorine-based surfactant.

When hydrophobic hydrocarbon-based surfactants are used in a water-based process solution composition that mainly uses ultrapure water, the photoresist wall surface may be imparted with hydrophobicity which may reduce melting and collapse of the photoresist pattern. In this case, however, the hydrocarbon-based surfactants have strong tendency to agglomerate, thereby deteriorating the uniformity in the properties of the process solution composition. The agglomerated hydrocarbon-based surfactants may cause defects during the use of the process solution composition. That is, when hydrocarbon-based surfactants are used, the usage thereof needs to be increased to reduce the pattern melting. In this case, there is a concern that the photoresist used will be damaged. In addition, when an excessive amount of an unsuitable surfactant is used to reduce the surface tension of the process solution composition and to reduce a capillary force, it causes pattern melting which leads to pattern collapsing.

In the present disclosure, a fluorine-based surfactant is used, and in addition, a pattern reinforcing agent represented by Formula (1) and a material selected from the group consisting of triol derivatives, tetraol derivatives, and mixtures thereof are used. It was confirmed that when the materials were used, the effect of lowering the pattern lifting defect level was improved.

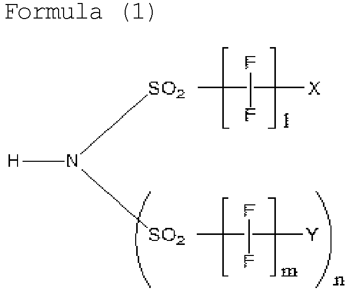

In Formula (1),
X and Y are each fluorine or C1-C5 alkyl;
X and Y each form a single bond;
l is within the range of from 1 to 5, m is within the range of from 0 to 5, and
n is within the range of from 0 to 2.

As a representative developing solution that is currently used in most of the photolithographic developing processes, tetramethylammonium hydroxide diluted with pure water (2.38□ by weight of tetramethylammonium hydroxide and 97.62□ by weight of water) is used.

It was found that in a photolithographic process, pattern lifting defects occurred in the case where a photoresist pattern was successively cleaned only with pure water after having been developed. In addition, it was also found that in a photolithographic process, a pattern collapse occurred in the case where a process solution composition containing tetramethylammonium hydroxide and pure water was successively applied after a photoresist pattern had been developed or in the case where a photoresist pattern was treated with pure water and then with the process solution composition after having been developed.

From the findings, it could be inferred that the pattern collapse occurred because the process solution composition containing tetramethylammonium hydroxide weakened the fine pattern that was exposed and because the capillary force was excessively strong or nonuniform.

Therefore, in order to prevent the exposed pattern from collapsing and to reduce the line width roughness (LWR) and the number of defects, there is a need to conduct study on a substance that exerts a relatively weak force on the exposed pattern than tetramethylammonium hydroxide.

In the present disclosure, a fluorine-based surfactant is used and a substance selected from triol derivatives, tetraol derivatives, and mixtures thereof is additionally used. By use of such a composition, it was confirmed that a pattern collapse was prevented and the LWR and/or the number of defects was reduced.

Preferably, as a first embodiment of the present disclosure, there is provided a process solution composition for lowering a lifting defect level for a photoresist pattern during photoresist development, the composition including: 0.00001% to 0.01% by weight of a fluorine-based surfactant, 0.00001% to 0.005% by weight of a pattern reinforcing agent represented by Formula (1), 0.00001% to 0.01% by weight of a material selected from the group consisting of triol derivatives, tetraol derivatives, and mixtures thereof, and the balance being water

More preferably, as a second embodiment of the present disclosure, there is provided a process solution composition for lowering a lifting defect level for a photoresist pattern during photoresist development, the composition including: 0.0001% to 0.01% by weight of a fluorine-based surfactant, 0.00001% to 0.005% by weight of a pattern reinforcing agent represented by formula (1), 0.00001% to 0.01% by weight of a material selected from the group consisting of triol derivatives, tetraol derivatives, and mixtures thereof, and the balance being water.

The most preferably, as a third embodiment of the present disclosure, there is provided a process solution composition for lowering a lifting defect level for a photoresist pattern during photoresist development, the composition including: 0.001% to 0.01% by weight of a fluorine-based surfactant, 0.00001% to 0.005% by weight of a pattern reinforcing agent represented by Formula (1), 0.00001% to 0.01% by weight of a material selected from the group consisting of triol derivatives, tetraol derivatives, and mixtures thereof, and the balance being water.

In the embodiments, the fluorine-based surfactant may be selected from the group consisting of fluoroacryl carboxylate, fluoroalkyl ether, fluoroalkylene ether, fluoroalkyl sulfate, fluoroalkyl phosphate, fluoroacryl co-polymer, fluoro co-polymer, perfluorinated acid, perfluorinated carboxylate, perfluorinated sulfonate, and mixtures thereof.

The pattern reinforcing agent represented by Formula (1) in the above embodiments may be any one selected from the group consisting of bis(1,1,2,2,3,3,3-heptafluoro-1-propanesulfonyl)imide, bis(1,1,2,2,3,3,4,4,4-nonafluoro-1-butanesulfonyl)imide, 1,1,2,2,3,3-hexafluoropropane-1,3-disulfonyimide, bis(trifluoromethanesulfonyl)imide, and mixtures thereof.

In the embodiments, the triol derivatives may be C3 to C10 triols and may be selected from the group consisting of 1,2,3-propanetriol, 1,2,4-butanetriol, 1,1,4-butanetriol, 1,3,5-pentanetriol, 1,2,5-pentanetriol, 2,3,4-pentanetriol, 1,2,3-hexanetriol, 1,2,6-hexanetriol, 1,3,4-hexanetriol, 1,4,5-hexanetriol, 2,3,4-hexanetriol, 1,2,3-heptanetriol, 1,2,4-heptanetriol, 1,2,6-heptanetriol, 1,3,5-heptanetriol, 1,4,7-heptanetriol, 2,3,4-heptanetriol, 2,4,6-heptanetriol, 1,2,8-octanetriol, 1,3,5-octanetriol, 1,4,7-octanetriol, butane-1,1,1-triol, 2-methyl-1,2,3-propanetriol, 5-methylhexane-1,2,3-triol, 2,6-dimethyl-3-heptene-2,4,6,-triol, benzene-1,3,5-triol, 2-methyl-benzene-1,2,3-triol, 5-methyl-benzene-1,2,3-triol, 2,4,6,-trimethylbenzene-1,3,5-triol, naphthalene-1,4,5-triol, 5,6,7,8-tetrahydronaphthalene-1,6,7-triol, 5-hydromethylbenzene-1,2,3-triol, 5-isopropyl-2-methyl-5-cyclohexene-1,2,4-triol, 4-isopropyl-4-cyclohexene-1,2,3-triol, and mixtures thereof.

In the embodiments, the tetraol derivatives may be C4 to C14 tetraols and may be selected from the group consisting of 1,2,3,4-butanetetraol, 1,2,3,4-pentanetetraol, 1,2,4,5-pentanetetraol, 1,2,3,4-hexanetetraol, 1,2,3,5-hexanetetraol, 1,2,3,6-hexanetetraol, 1,2,4,5-hexanetetraol, 1,2,4,6-hexanetetraol, 1,2,5,6-hexanetetraol, 1,3,4,5-hexanetetraol, 1,3,4,6-hexanetetraol, 2,3,4,5-hexanetetraol, 1,2,6,7-heptanetetraol, 2,3,4,5-heptanetetraol, 1,1,1,2-octanetetraol, 1,2,7,8-octanetetraol, 1,2,3,8-octanetetraol, 1,3,5,7-octanetetraol, 2,3,5,7-octanetetraol, 4,5,6,7-octanetetraol, 3,7-dimethel-3-octene-1,2,6,7-tetraol, 3-hexyne-1,2,5,6-tetraol, 2,5-dimethyl-3-hexyne-1,2,5,6-tetraol, anthracene-1,4,9,10-tetraol, and mixtures thereof.

The present disclosure also provides a method of forming a photoresist pattern, the method including: (a) applying a photoresist on a semiconductor substrate to form a photoresist film; (b) exposing the photoresist film to light and developing the photoresist film to form a photoresist pattern; and (c) cleaning the photoresist pattern with the process solution composition.

It was thought that the pattern collapse was caused by the capillary force between patterned features when the pattern was cleaned with pure water after the photoresist development. However, it was experimentally recognized that only the reduction of the capillary force could neither completely prevent the pattern collapse nor reduce the number of lifting defects.

When an unsuitable surfactant is used in an excessive amount to reduce the surface tension of the process solution composition and hence to reduce the capillary force, pattern melting is caused, which rather results in an increase in the number of lifting defects in the pattern.

In order to reduce the number of lifting defects in the pattern, it is important to select an appropriate surfactant that can reduce the surface tension of the process solution composition and can the photoresist pattern from melting.

The process solution composition according to the present disclosure is useful for photoresist patterning and particularly exhibits the effect of reducing the number of pattern lifting defects occurring while photoresist development.

### Advantageous Effects

The process solution composition according to the present disclosure provides the effect of lowering the pattern lifting defect level, the effect being unable to be achieved when a photoresist is used alone to form a photoresist pattern. The photoresist forming method including a step of cleaning a photoresist pattern with the process solution composition can achieve the effect of greatly reducing manufacturing cost.

### Description of Drawings

FIG. 1 is a view illustrating results of evaluation for lifting defects of a photoresist pattern, according to Example 1; and
FIG. 2 is a view illustrating results of evaluation for lifting defects of a photoresist pattern, Comparative Example 1.

### Best Mode

Hereinafter, the present disclosure will be described in detail.

The present disclosure, which is the result of conducting intensive and extensive research over a long period of time, relates to a "process solution composition for lowering a lifting defect level of a photoresist pattern, the process solution composition including: 0.00001% to 0.01% by weight of a fluorine-based surfactant selected from the group consisting of fluoroacryl carboxylate, fluoroalkyl ether, fluoroalkylene ether, fluoroalkyl sulfate, fluoroalkyl phosphate, fluoroacryl co-polymer, fluoro co-polymer, perfluorinated acid, perfluorinated carboxylate, perfluorinate sulfonate, and mixtures thereof; 0.00001% to 0.005% by weight of a pattern reinforcing agent represented by Formula (1) and selected from the group consisting of bis(1,1,2,2,3,3,3-heptafluoro-1-propanesulfonyl)imide, bis(1,1,2,2,3,3,4,4,4-nonafluoro-1-butanesulfonyl)imide, 1,1,2,2,3,3-hexafluoropropane-1,3-disulfonylimide, bis(trifluoromethanesulfonyl)imide, and mixture thereof; 0.00001% to 0.01% by weight of a C3 to C10 triol derivative, a C4 to C14 tetraol derivative, or a combination thereof; and the balance being water". Here, the C3 to C10 triol derivative is selected from the group consisting of 1,2,3-propanetriol, 1,2,4-butanetriol, 1,1,4-butanetriol, 1,3,5-pentanetriol, 1,2,5-pentanetriol, 2,3,4-pentanetriol, 1,2,3-hexanetriol, 1,2,6-hexanetriol, 1,3,4-hexanetriol, 1,4,5-hexanetriol, 2,3,4-hexanetriol, 1,2,3-heptanetriol, 1,2,4-heptanetriol, 1,2,6-heptanetriol, 1,3,5-heptanetriol, 1,4,7-heptanetriol, 2,3,4-heptanetriol, 2,4,6-heptanetriol, 1,2,8-octanetriol, 1,3,5-octanetriol, 1,4,7-octanetriol, butane-1,1,1-triol, 2-methyl-1,2,3-propanetriol, 5-methylhexane-1,2,3-triol, 2,6-dimethyl-3-heptene-2,4,6,-triol, benzene-1,3,5-triol, 2-methyl-benzene-1,2,3-triol, 5-methyl-benzene-1,2,3-triol, 2,4,6,-trimethylbenzene-1,3,5-triol, naphthalene-1,4,5-triol, 5,6,7,8-tetrahydro Naphthalene-1, 6, 7-triol, 5-hydromethylbenzene-1,2,3-triol, 5-isopropyl-2-methyl-5-cyclohexene-1,2,4-triol, 4-isopropyl-4-cyclohexene-1,2,3-triol, and mixtures thereof. Here, the C4 to C10 tetraol derivative is selected from the group consisting of 1,2,3,4-butanetetraol, 1,2,3,4-pentanetetraol, 1,2,4,5-pentanetetraol, 1,2,3,4-hexanetetraol, 1,2,3,5-hexanetetraol, 1,2,3,6-hexanetetraol, 1,2,4,5-hexanetetraol, 1,2,4,6-hexanetetraol, 1,2,5,6-hexanetetraol, 1,3,4,5-hexanetetraol, 1,3,4,6-hexanetetraol, 2,3,4,5-hexanetetraol, 1,2,6,7-heptanetetraol, 2,3,4,5-heptanetetraol, 1,1,1,2-octanetetraol, 1,2,7,8-octanetetraol, 1,2,3,8-octanetetraol, 1,3,5,7-octanetetraol, 2,3,5,7-octanetetraol, 4,5,6,7-octanetetraol, 3,7-dimethel-3-octene-1,2,6,7-tetraol, 3-hexyne-1,2,5,6-tetraol, 2,5-dimethyl-3-hexyne-1,2,5,6-tetraol, anthracene-1,4,9,10-tetraol, and mixtures thereof. Examples of the constitutional components and composition ratio of the process solution composition according to the present disclosure are referred to as Examples 1 to 65. Examples of the constitutional components and composition ratio to be compared with the process solution composition of the present disclosure are referred to as Comparative Examples 1 to 19.

### Mode for Carrying out the Invention

Herein after, the preferred examples of the present disclosure and comparative examples will be described. However, the preferred examples described below are presented only for illustrative purposes and are not intended to limit the present disclosure.

### [Example 1]

A process solution composition for EUV photolithography to lower a photoresist pattern collapse level was prepared using a method described below. The composition included 0.001% by weight of fluoroacrylic carboxylate, 0.0001% by weight of bis(trifluoromethanesulfonyl)imide, and 0.001% by weight of 1,2,3-propanetriol.

0.001% by weight of fluoroacrylic carboxylate, 0.0001% by weight of bis(trifluoromethanesulfonyl)imide, and 0.001% by weight of 1,2,3-propanetriol were added to the balance being distilled water, and then stirred for 6 hours. The mixture was filtered with a 0.01-um filter to remove impurity of fine particles. Thus, a process solution composition for lowering a photoresist pattern defect level was obtained.

### [Examples 2 to 65]

Process solution compositions for lowering a photoresist pattern defect level were prepared in the same manner as described in Example 1, according to the composition ratios specified in Tables 1 to 16.

### [Comparative Example 1]

Distilled water to be used as a cleaning liquid in the last stage of a development process among typical semiconductor device manufacturing processes was prepared.

### [Comparative Examples 2 to 19]

For comparison with Examples, process liquid compositions were prepared in the same manner as in Example 1, according to the component ratios specified in Tables 1 to 16.

### [Experimental Examples 1 to 65 and Comparative Experimental Examples 1 to 19]

A chemically amplified PHS acrylate hydrate hybrid EUV resist was applied by spin coating on a 12-inch silicon wafer (manufactured by SK Siltron) and baked at 110°C for 60 seconds by soft baking to form a resist film with a thickness of 40 nm. The resist film on the wafer was exposed through an 18-nm mask (line:space = 1:1) in an EUV exposure apparatus , and the wafer was baked (PEB) at 110°C for 60 seconds. Then, the resist film was developed by puddle development with a 2.38% tetramethylammonium hydroxide (TMAH) aqueous solution for 40 seconds. Deionized water (DI water) was poured into a puddle of developer on the wafer, and the wafer was rotated with DI water being continuously poured until the puddle of the developer was replaced with a puddle of DI water. The rotation of the water was stopped with the puddle of DI water present on the wafer. Subsequently, the rinse compositions of Experimental Examples 1 to 65 and Comparative Examples 2 to 19 were poured into the puddle of DI water on the wafer, and the wafer was rotated to be dried at high speed.

Measurements of pattern lifting defect levels were performed on the silicon wafers on which patterns are formed using the compositions prepared in Examples 1 to 65 and Comparative Examples 1 to 19. The resulting measurements were denoted as Experimental Examples 1 to 65 and Comparative Experimental Examples 1 to 19. The measurement results are shown in Table 17.

### (1) Checking of Pattern Lifting Prevention

After exposure energy was split, among a total of 89 blocks, the number of blocks in which a pattern did not collapse was determined using a critical dimension-scanning electron microscope (CD-SEM, manufactured by Hitachi).

### (2) Transparency

Transparency of each of the prepared process liquid compositions was checked with the naked eye and was marked as "transparent" or "opaque".

**[Table 1]**

| | Surfactant | | Pattern reinforcing agent | | Additive | | Distilled water | |
|---|---|---|---|---|---|---|---|---|
| | Name | Con. (w t% | Name | Con. (wt%) | Name | Con. (wt%) | Name | Con. (wt%) |
| Ex. 1 | Fluoroacrylic carboxylate | 0.001 | Bis(trifluoromethane sulfonyl) imide | 0.0001 | 1,2,3-propane triol | 0.001 | Distilled water | 99.9979 |
| Ex. 2 | Fluoroalkyl ether | 0.001 | Bis(trifluoromethane sulfonyl) imide | 0.0001 | 1,2,3-propane triol | 0.001 | Distilled water | 99.9979 |
| Ex. 3 | Fluoroalkylene ether | 0.001 | Bis(trifluoromethane sulfonyl) imide | 0.0001 | 1,2,3-propane triol | 0.001 | Distilled water | 99.9979 |
| Ex. 4 | Fluoroalkyl sulfate | 0.001 | Bis(trifluoromethane sulfonyl) imide | 0.0001 | 1,2,3-propane triol | 0.001 | Distilled water | 99.9979 |
| Ex. 5 | Fluoroalkyl phosphate | 0.001 | Bis(trifluoromethane sulfonyl) imide | 0.0001 | 1,2,3-propane triol | 0.001 | Distilled water | 99.9979 |
| Ex. 6 | Fluoroacrylic copolymer | 0.001 | Bis(trifluoromethane sulfonyl) imide | 0.0001 | 1,2,3-propane triol | 0.001 | Distilled water | 99.9979 |
| Ex. 7 | Fluorine copolymer | 0.001 | Bis(trifluoromethane sulfonyl) imide | 0.0001 | 1,2,3-propane triol | 0.001 | Distilled water | 99.9979 |
| Ex. 8 | Perfluoric acid | 0.001 | Bis(trifluoromethane sulfonyl) imide | 0.0001 | 1,2,3-propane triol | 0.001 | Distilled water | 99.9979 |
| Ex. 9 | Perfluorinated carboxyl salts | 0.001 | Bis(trifluoromethane sulfonyl) imide | 0.0001 | 1,2,3-propane triol | 0.001 | Distilled water | 99.9979 |
| Ex. 10 | Perfluorinated sulfonate | 0.001 | Bis(trifluoromethane sulfonyl) imide | 0.0001 | 1,2,3-propane triol | 0.001 | Distilled water | 99.9979 |
| Comparative Ex. 1 | - | - | | | - | - | Distilled water | 100 |

**[Table 2]**

| | Surfactant | | Pattern reinforcing agent | | Additive | | Distilled water | |
|---|---|---|---|---|---|---|---|---|
| | Name | Con. (wt%) | Name | Con. (wt%) | Name | Con. (wt%) | Name | Con. (wt%) |
| Ex. 11 | Fluoroacrylic carboxylate | 0.001 | Bis(trifluoromethanesulfonyl)i mide | 0.0001 | 1,2,3,4-Butanetetra ol | 0.001 | Distilled water | 99.9979 |
| Ex. 12 | Fluoroalkyl ether | 0.001 | Bis(trifluoromethanesulfonyl)i mide | 0.0001 | 1,2,3,4-Butanetetra ol | 0.001 | Distilled water | 99.9979 |
| Ex. 13 | Fluoroalkylene ether | 0.001 | Bis(trifluoromethanesulfonyl)i mide | 0.0001 | 1,2,3,4-Butanetetra ol | 0.001 | Distilled water | 99.9979 |
| Ex. 14 | Fluoroalkyl sulfate | 0.001 | Bis(trifluoromethanesulfonyl)i mide | 0.0001 | 1,2,3,4-Butanetetra ol | 0.001 | Distilled water | 99.9979 |
| Ex. 15 | Fluoroalkyl phosphate | 0.001 | Bis(trifluoromethanesulfonyl)i mide | 0.0001 | 1,2,3,4-Butanetetra ol | 0.001 | Distilled water | 99.9979 |
| Ex. 16 | Fluoroacrylic copolymer | 0.001 | Bis(trifluoromethanesulfonyl)i mide | 0.0001 | 1,2,3,4-Butanetetra ol | 0.001 | Distilled water | 99.9979 |
| Ex. 17 | Fluorine copolymer | 0.001 | Bis(trifluoromethanesulfonyl)i mide | 0.0001 | 1,2,3,4-Butanetetra ol | 0.001 | Distilled water | 99.9979 |
| Ex. 18 | Perfluoric acid | 0.001 | Bis(trifluoromethanesulfonyl)i mide | 0.0001 | 1,2,3,4-Butanetetra ol | 0.001 | Distilled water | 99.9979 |
| Ex. 19 | Perfluorinated carboxyl salts | 0.001 | Bis(trifluoromethanesulfonyl)i mide | 0.0001 | 1,2,3,4-Butanetetra ol | 0.001 | Distilled water | 99.9979 |
| Ex. 20 | Perfluorinated sulfonate | 0.001 | Bis(trifluoromethanesulfonyl)imide | 0.0001 | 1,2,3,4-Butanetetra ol | 0.001 | Distilled water | 99.9979 |

**[Table 3]**

| | Surfactant | | Pattern reinforcing agent | | Additive | | Distilled water | |
|---|---|---|---|---|---|---|---|---|
| | Name | Con. (wt%) | Name | Con. (wt%) | Name | Con. (wt%) | Name | Con. (wt%) |
| Ex. 21 | Fluoroacryl ic carboxylate | 0.00001 | Bis(trifluoromethanesulf onyl)imide | 0.0001 | 1,2,3-propanet riol | 0.001 | Distil led water | 99.9989 |
| Ex. 22 | Fluoroacryl ic carboxylate | 0.0001 | Bis(trifluoromethanesulf onyl)imide | 0.0001 | 1,2,3-propanet riol | 0.001 | Distil led water | 99.9988 |
| Ex. 1 | Fluoroacryl ic carboxylate | 0.001 | Bis(trifluoromethanesulf onyl)imide | 0.0001 | 1,2,3-propanet riol | 0.001 | Distil led water | 99.9979 |
| Ex. 23 | Fluoroacryl ic carboxylate | 0.01 | Bis(trifluoromethanesulf onyl)imide | 0.0001 | 1,2,3-propanet riol | 0.001 | Distil led water | 99.9889 |
| Comparative Ex. 2 | Fluoroacryl ic carboxylate | 0.1 | Bis(trifluoromethanesulf onyl) imide | 0.0001 | 1,2,3-propanet riol | 0.001 | Distil led water | 99.8989 |

**[Table 4]**

| | Surfactant | | Pattern reinforcing agent | | Additive | | Distilled water | |
|---|---|---|---|---|---|---|---|---|
| | Name | Con. (wt%) | Name | Con. (wt%) | Name | Con. (wt%) | Name | Con. (wt%) |
| Ex. 24 | Fluoroalkyl ether | 0.00001 | Bis(trifluorometh anesulfonyl) imide | 0.0001 | 1,2,3-propanetri ol | 0.001 | Distille d water | 99.9989 |
| Ex. 25 | Fluoroalkyl ether | 0.0001 | Bis(trifluorometh anesulfonyl) imide | 0.0001 | 1,2,3-propanetri ol | 0.001 | Distille d water | 99.9988 |
| Ex. 2 | Fluoroalkyl ether | 0.001 | Bis(trifluorometh anesulfonyl) imide | 0.0001 | 1,2,3-propanetri ol | 0.001 | Distille d water | 99.9979 |
| Ex. 26 | Fluoroalkyl ether | 0.01 | Bis(trifluorometh anesulfonyl) imide | 0.0001 | 1,2,3-propanetri ol | 0.001 | Distille d water | 99.9889 |
| Comparative Ex. 3 | Fluoroalkyl ether | 0.1 | Bis (trifluoromethanesulfonyl)imide | 0.0001 | 1,2,3-propanetri ol | 0.001 | Distilled water | 99.8989 |

**[Table 5]**

| | Surfactant | | Pattern reinforcing agent | | Additive | | Distilled water | |
|---|---|---|---|---|---|---|---|---|
| | Name | Con. (wt%) | Name | Con. (wt%) | Name | Con. (wt%) | Name | Con. (wt%) |
| Ex. 27 | Fluoroalkyl ene ether | 0.00001 | Bis(trifluoromethanesul fonyl)imide | 0.0001 | 1,2,3-propanetr iol | 0.001 | Distil led water | 99.9989 |
| Ex. 28 | Fluoroalkyl ene ether | 0.0001 | Bis(trifluoromethanesul fonyl)imide | 0.0001 | 1,2,3-propanetr iol | 0.001 | Distil led water | 99.9988 |
| Ex. 3 | Fluoroalkyl ene ether | 0.001 | Bis(trifluoromethanesul fonyl)imide | 0.0001 | 1,2,3-propanetr iol | 0.001 | Distil led water | 99.9979 |
| Ex. 29 | Fluoroalkyl ene ether | 0.01 | Bis(trifluoromethanesul fonyl)imide | 0.0001 | 1,2,3-propanetr iol | 0.001 | Distil led water | 99.9889 |
| Compara tive Ex. 4 | Fluoroalkyl ene ether | 0.1 | Bis(trifluoromethanesul fonyl)imide | 0.0001 | 1,2,3-propanetr iol | 0.001 | Distil led water | 99.8989 |

**[Table 6]**

| | Surfactant | | Pattern reinforcing agent | | Additive | | Distilled water | |
|---|---|---|---|---|---|---|---|---|
| | Name | Con. (wt%) | Name | Con. (wt%) | Name | Con. (wt%) | Name | Con. (wt%) |
| Ex. 30 | Fluoroal kyl sulfate | 0.00001 | Bis(trifluoromethanesulfo nyl)imide | 0.0001 | 1,2,3-propanet riol | 0.001 | Distill ed water | 99.9989 |
| Ex. 31 | Fluoroal kyl sulfate | 0.0001 | Bis(trifluoromethanesulfo nyl)imide | 0.0001 | 1,2,3-propanet riol | 0.001 | Distill ed water | 99.9988 |
| Ex. 4 | Fluoroal kyl sulfate | 0.001 | Bis(trifluoromethanesulfo nyl)imide | 0.0001 | 1,2,3-propanet riol | 0.001 | Distill ed water | 99.9979 |
| Ex. 32 | Fluoroal kyl sulfate | 0.01 | Bis(trifluoromethanesulfo nyl)imide | 0.0001 | 1,2,3-propanet riol | 0.001 | Distill ed water | 99.9889 |
| Compara tive Ex. 5 | Fluoroalkyl sulfate | 0.1 | Bis(trifluoromethanesulfo nyl)imide | 0.0001 | 1,2,3-propanetriol | 0.001 | Distill ed water | 99.8989 |

**[Table 7]**

| | Surfactant | | Pattern reinforcing agent | | Additive | | Distilled water | |
|---|---|---|---|---|---|---|---|---|
| | Name | Con. (wt%) | Name | Con. (wt%) | Name | Con. (wt%) | Name | Con. (wt%) |
| Ex. 33 | Fluoroal kyl phosphat e | 0.00001 | Bis(trifluoromethanesul fonyl)imide | 0.0001 | 1,2,3-propanetr iol | 0.001 | Distil led water | 99.9989 |
| Ex. 34 | Fluoroal kyl phosphat e | 0.0001 | Bis(trifluoromethanesul fonyl)imide | 0.0001 | 1,2,3-propanetr iol | 0.001 | Distil led water | 99.9988 |
| Ex. 5 | Fluoroal kyl phosphat e | 0.001 | Bis(trifluoromethanesul fonyl)imide | 0.0001 | 1,2,3-propanetr iol | 0.001 | Distil led water | 99.9979 |
| Ex. 35 | Fluoroal kyl phosphat e | 0.01 | Bis(trifluoromethanesul fonyl)imide | 0.0001 | 1,2,3-propanetr iol | 0.001 | Distil led water | 99.9889 |
| Comparativ e Ex. 6 | Fluoroal kyl phosphat e | 0.1 | Bis(trifluoromethanesul fonyl)imide | 0.0001 | 1,2,3-propanetr iol | 0.001 | Distil led water | 99.8989 |

**[Table 8]**

| | Surfactant | | Pattern reinforcing agent | | Additive | | Distilled water | |
|---|---|---|---|---|---|---|---|---|
| | Name | Con. (wt%) | Name | Con. (wt%) | Name | Con. (wt%) | Name | Con. (wt%) |
| Ex. 36 | Fluoroacry lic copolymer | 0.00001 | Bis(trifluoromethanesulf onyl)imide | 0.0001 | 1,2,3-propanetr iol | 0.001 | Distill ed water | 99.9989 |
| Ex. 37 | Fluoroacry lic copolymer | 0.0001 | Bis(trifluoromethanesulf onyl)imide | 0.0001 | 1,2,3-propanetr iol | 0.001 | Distill ed water | 99.9988 |
| Ex. 6 | Fluoroacry lic copolymer | 0.001 | Bis(trifluoromethanesulf onyl)imide | 0.0001 | 1,2,3-propanetr iol | 0.001 | Distill ed water | 99.9979 |
| Ex. 38 | Fluoroacrylie copolymer | 0.01 | Bis(trifluoromethanesulfonyl)imide | 0.0001 | 1,2,3-propanetr iol | 0.001 | Distilled water | 99.9889 |
| Compara tive Ex. 7 | Fluoroacry lic copolymer | 0.1 | Bis(trifluoromethanesulf onyl)imide | 0.0001 | 1,2,3-propanetr iol | 0.001 | Distill ed water | 99.8989 |

**[Table 9]**

| | Surfactant | | Pattern reinforcing agent | | Additive | | Distilled water | |
|---|---|---|---|---|---|---|---|---|
| | Name | Con. (wt%) | Name | Con. (wt%) | Name | Con. (wt%) | Name | Con. (wt%) |
| Ex. 39 | Fluorine copolyme r | 0.00001 | Bis(trifluoromethanesulfo nyl)imide | 0.0001 | 1,2,3-propanetri ol | 0.001 | Distil led water | 99.9989 |
| Ex. 40 | Fluorine copolyme r | 0.0001 | Bis(trifluoromethanesulfo nyl)imide | 0.0001 | 1,2,3-propanetri ol | 0.001 | Distil led water | 99.9988 |
| Ex. 7 | Fluorine copolyme r | 0.001 | Bis(trifluoromethanesulfo nyl)imide | 0.0001 | 1,2,3-propanetri ol | 0.001 | Distil led water | 99.9979 |
| Ex. 41 | Fluorine copolyme r | 0.01 | Bis(trifluoromethanesulfo nyl)imide | 0.0001 | 1,2,3-propanetri ol | 0.001 | Distil led water | 99.9889 |
| Compara tive Ex. 8 | Fluorine copolyme r | 0.1 | Bis(trifluoromethanesulfo nyl)imide | 0.0001 | 1,2,3-propanetri ol | 0.001 | Distil led water | 99.8989 |

**[Table 10]**

| | Surfactant | | Pattern reinforcing agent | | Additive | | Distilled water | |
|---|---|---|---|---|---|---|---|---|
| | Name | Con. (wt%) | Name | Con. (wt%) | Name | Con. (wt%) | Name | Con. (wt%) |
| Ex. 42 | Perfluo ric acid | 0.00001 | Bis(trifluoromethanesulf onyl)imide | 0.0001 | 1,2,3-propane triol | 0.001 | Disti lled water | 99.9989 |
| Ex. 43 | Perfluo ric acid | 0.0001 | Bis(trifluoromethanesulf onyl)imide | 0.0001 | 1,2,3-propane triol | 0.001 | Disti lled water | 99.9988 |
| Ex. 8 | Perfluo ric acid | 0.001 | Bis(trifluoromethanesulf onyl)imide | 0.0001 | 1,2,3-propane triol | 0.001 | Disti lled water | 99.9979 |
| Ex. 44 | Perfluo ric | 0.01 | Bis(trifluoromethanesulf onyl)imide | 0.0001 | 1,2,3-propane | 0.001 | Disti lled | 99.9889 |
| | acid | | | | triol | | water | |
| Comparative Ex. 9 | Perfluo ric acid | 0.1 | Bis(trifluoromethanesulf onyl)imide | 0.0001 | 1,2,3-propane triol | 0.001 | Disti lled water | 99.8989 |

**[Table 11]**

| | Surfactant | | Pattern reinforcing agent | | Additive | | Distilled water | |
|---|---|---|---|---|---|---|---|---|
| | Name | Con. (wt%) | Name | Con. (wt%) | Name | Con. (wt%) | Name | Con. (wt%) |
| Ex. 45 | Perfluorina ted carboxyl salts | 0.00001 | Bis(trifluoromethanes ulfonyl) imide | 0.0001 | 1,2,3-propane triol | 0.001 | Distill ed water | 99.9989 |
| Ex. 46 | Perfluorina ted carboxyl salts | 0.0001 | Bis(trifluoromethanes ulfonyl)imide | 0.0001 | 1,2,3-propane triol | 0.001 | Distill ed water | 99.9988 |
| Ex. 9 | Perfluorina ted carboxyl salts | 0.001 | Bis(trifluoromethanes ulfonyl)imide | 0.0001 | 1,2,3-propane triol | 0.001 | Distill ed water | 99.9979 |
| Ex. 47 | Perfluorina ted carboxyl salts | 0.01 | Bis(trifluoromethanes ulfonyl)imide | 0.0001 | 1,2,3-propane triol | 0.001 | Distill ed water | 99.9889 |
| Comparat ive Ex. 10 | Perfluorina ted carboxyl salts | 0.1 | Bis(trifluoromethanes ulfonyl)imide | 0.0001 | 1,2,3-propane triol | 0.001 | Distill ed water | 99.8989 |

**[Table 12]**

| | Surfactant | | Pattern reinforcing agent | | Additive | | Distilled water | |
|---|---|---|---|---|---|---|---|---|
| | Name | Con. (wt%) | Name | Con. (wt%) | Name | Con. (wt%) | Name | Con. (wt%) |
| Ex. 48 | Perfluorina ted sulfonate | 0.00001 | Bis(trifluoromethanes ulfonyl) imide | 0.0001 | 1,2,3-propane triol | 0.001 | Distill ed water | 99.9989 |
| Ex. 49 | Perfluorina ted sulfonate | 0.0001 | Bis(trifluoromethanes ulfonyl) imide | 0.0001 | 1,2,3-propane triol | 0.001 | Distill ed water | 99.9988 |
| Ex. 10 | Perfluorina ted sulfonate | 0.001 | Bis(trifluoromethanes ulfonyl) imide | 0.0001 | 1,2,3-propanetriol | 0.001 | Distill ed water | 99.9979 |
| Ex. 50 | Perfluorina ted sulfonate | 0.01 | Bis(trifluoromethanes ulfonyl)imide | 0.0001 | 1,2,3-propane triol | 0.001 | Distill ed water | 99.9889 |
| Comparat ive Ex. 11 | Perfluorina ted sulfonate | 0.1 | Bis(trifluoromethanes ulfonyl)imide | 0.0001 | 1,2,3-propane triol | 0.001 | Distill ed water | 99.8989 |

**[Table 13]**

| | Surfactant | | Pattern reinforcing agent | | Additive | | Distilled water | |
|---|---|---|---|---|---|---|---|---|
| | Name | Con. (wt%) | Name | Con. (wt%) | Name | Con. (wt%) | Name | Con. (wt%) |
| Ex. 51 | Fluoroacryl ic carboxylate | 0.001 | Bis(trifluoromethanesu lfonyl)imide | 0.00001 | 1,2,3-propane triol | 0.001 | Disti lled water | 99.9980 |
| Ex. 1 | Fluoroacryl ic carboxylate | 0.001 | Bis(trifluoromethanesu lfonyl)imide | 0.0001 | 1,2,3-propane triol | 0.001 | Disti lled water | 99.9979 |
| Ex. 52 | Fluoroacryl ic carboxylate | 0.001 | Bis(trifluoromethanesu lfonyl)imide | 0.001 | 1,2,3-propane triol | 0.001 | Disti lled water | 99.9970 |
| Ex. 53 | Fluoroacryl ic carboxylate | 0.001 | Bis(trifluoromethanesu lfonyl)imide | 0.005 | 1,2,3-propane triol | 0.001 | Disti lled water | 99.9930 |
| Comparat ive Ex. 12 | Fluoroacryl ic carboxylate | 0.001 | Bis(trifluoromethanesu lfonyl)imide | 0.01 | 1,2,3-propane triol | 0.001 | Disti lled water | 99.9880 |
| Comparat ive Ex. 16 | Fluoroacryl ic carboxylate | 1.001 | Bis(trifluoromethanesu lfonyl)imide | 0.1 | 1,2,4-propane triol | 1.001 | Disti lled water | 97.8980 |

**[Table 14]**

| | Surfactant | | Pattern reinforcing agent | | Additive | | Distilled water | |
|---|---|---|---|---|---|---|---|---|
| | Name | Con. (wt%) | Name | Con. (wt%) | Name | Con. (wt%) | Name | Con. (wt%) |
| Ex. 54 | Fluoroacryl ic carboxylate | 0.001 | Bis(1,1,2,2,3,3,3 -heptafluoro-1-propanesulfonyl)i mide | 0.0000 1 | 1,2,3-propanetri ol | 0.001 | Distilled water | 99.9980 |
| Ex. 55 | Fluoroacryl ic carboxylate | 0.001 | Bis(1,1,2,2,3,3,3-heptafluoro-2-propanesulfonyl)i mide | 0.0001 | 1,2,3-propanetri ol | 0.001 | Distilled water | 99.9979 |
| Ex. 56 | Fluoroacryl ic carboxylate | 0.001 | Bis(1,1,2,2,3,3,3 -heptafluoro-3-propanesulfonyl)i mide | 0.001 | 1,2,3-propanetri ol | 0.001 | Distilled water | 99.9970 |
| Ex. 57 | Fluoroacryl ic carboxylate | 0.001 | Bis(1,1,2,2,3,3,3 -heptafluoro-4-propanesulfonyl)i mide | 0.005 | 1,2,3-propanetri ol | 0.001 | Distilled water | 99.9930 |
| Comparat ive Ex. 13 | Fluoroacryl ic carboxylate | 0.001 | Bis(1,1,2,2,3,3,3 -heptafluoro-5-propanesulfonyl)i mide | 0.01 | 1,2,3-propanetri ol | 0.001 | Distilled water | 99.9880 |
| Comparat ive Ex. 17 | Fluoroacryl ic carboxylate | 1.001 | Bis(1,1,2,2,3,3,3 -heptafluoro-6-propanesulfonyl)i mide | 0.1 | 1,2,4-propanetri ol | 1.001 | Distilled water | 97.8980 |

**[Table 15]**

| | Surfactant | | Pattern reinforcing agent | | Additive | | Distilled water | |
|---|---|---|---|---|---|---|---|---|
| | Name | Con. (wt%) | Name | Con. (wt%) | Name | Con. (wt%) | Name | Con. (wt%) |
| Ex. 58 | Fluoroacryl ic carboxylate | 0.001 | Bis(1,1,2,2,3,3,4 ,4,4-nonafluoro-1-butanesulfonyl)im ide | 0.00001 | 1,2,3-propanet riol | 0.001 | Distill ed water | 99.9980 |
| Ex. 59 | Fluoroacryl ic carboxylate | 0.001 | Bis(1,1,2,2,3,3,4 ,4,4-nonafluoro-2-butanesulfonyl)im ide | 0.0001 | 1,2,3-propanet riol | 0.001 | Distill ed water | 99.9979 |
| Ex. 60 | Fluoroacryl ic carboxylate | 0.001 | Bis(1,1,2,2,3,3,4 ,4,4-nonafluoro-3-butanesulfonyl)im ide | 0.001 | 1,2,3-propanet riol | 0.001 | Distill ed water | 99.9970 |
| Ex. 61 | Fluoroacryl ic carboxylate | 0.001 | Bis(1,1,2,2,3,3,4 ,4,4-nonafluoro-4-butanesulfonyl)im ide | 0.005 | 1,2,3-propanet riol | 0.001 | Distill ed water | 99.9930 |
| Comparativ e Ex. 14 | Fluoroacryl ic carboxylate | 0.001 | Bis(1,1,2,2,3,3,4 ,4,4-nonafluoro-5-butanesulfonyl)im ide | 0.01 | 1,2,3-propanet riol | 0.001 | Distill ed water | 99.9880 |
| Comparativ e Ex. 18 | Fluoroacryl ic carboxylate | 0.001 | Bis(1,1,2,2,3,3,4 ,4,4-nonafluoro-5-butanesulfonyl)im ide | 0.1 | 1,2,3-propanet riol | 0.001 | Distill ed water | 99.8980 |

**[Table 16]**

| | Surfactant | | Pattern reinforcing agent | | Additive | | Distilled water | |
|---|---|---|---|---|---|---|---|---|
| | Name | Con. (wt%) | Name | Con. (wt%) | Name | Con. (wt%) | Name | Con. (wt%) |
| Ex. 62 | Fluoroacryli c carboxylate | 0.001 | 1,1,2,2,3,3-Hexafluoropropan e-1,3-disulfonylimide | 0.00001 | 1,2,3-propanetri ol | 0.001 | Distill ed water | 99.9980 |
| Ex. 63 | Fluoroacryli c carboxylate | 0.001 | 1,1,2,2,3,3-hexafluoropropan e-1,4-disulfonylimide | 0.0001 | 1,2,3-propanetri ol | 0.001 | Distill ed water | 99.9979 |
| Ex. 64 | Fluoroacryli c carboxylate | 0.001 | 1,1,2,2,3,3-hexafluoropropan e-1,5-disulfonylimide | 0.001 | 1,2,3-propanetri ol | 0.001 | Distill ed water | 99.9970 |
| Ex. 65 | Fluoroacryli c carboxylate | 0.001 | 1,1,2,2,3,3-hexafluoropropan e-1,6-disulfonylimide | 0.005 | 1,2,3-propanetri ol | 0.001 | Distill ed water | 99.9930 |
| Comparativ e Ex. 15 | Fluoroacryli c carboxylate | 0.001 | 1,1,2,2,3,3-hexafluoropropan e-1,7-disulfonylimide | 0.01 | 1,2,3-propanetri ol | 0.001 | Distill ed water | 99.9880 |
| Comparativ e Ex. 19 | Fluoroacryli c carboxylate | 0.001 | 1,1,2,2,3,3-hexafluoropropan e-1,7-disulfonylimide | 0.1 | 1,2,3-propanetri ol | 0.001 | Distill ed water | 99.8980 |

### [Experimental Examples 1 to 65 and Comparative Experimental Examples 1 to 19]

The pattern lifting defect level and transparency were determined for silicon wafers on which patterns were formed using the compositions of Examples 1 to 65 and Comparative Examples 1 to 19. The measurement results are denoted as Experimental Examples 1 to 65 and Comparative Experimental Examples 1 to 19 and are shown in Table 17.

### (1) Evaluation of Effect of Preventing Pattern Lifting

After exposure energy was split, among a total of 89 blocks, the number of blocks in which a pattern did not collapse was determined using a critical dimension-scanning electron microscope (CD-SEM, manufactured by Hitachi).

### (2) Transparency

Transparency of each of the prepared process liquid compositions was checked with the naked eye and was marked as "transparent" or "opaque".

**[Table 17]**

| | The number of blocks with no pattern lifting defects | Transparency |
|---|---|---|
| Experimental EX. 1 | 68 | Transparent |
| Experimental Ex. 2 | 68 | Transparent |
| Experimental Ex. 3 | 68 | Transparent |
| Experimental Ex. 4 | 67 | Transparent |
| Experimental Ex. 5 | 67 | Transparent |
| Experimental Ex. 6 | 66 | Transparent |
| Experimental Ex. 7 | 67 | Transparent |
| Experimental Ex. 8 | 65 | Transparent |
| Experimental Ex. 9 | 64 | Transparent |
| Experimental Ex. 10 | 64 | Transparent |
| Experimental Ex. 11 | 68 | Transparent |
| Experimental Ex. 12 | 68 | Transparent |
| Experimental Ex. 13 | 67 | Transparent |
| Experimental Ex. 14 | 66 | Transparent |
| Experimental Ex. 15 | 66 | Transparent |
| Experimental Ex. 16 | 64 | Transparent |
| Experimental Ex. 17 | 63 | Transparent |
| Experimental Ex. 18 | 64 | Transparent |
| Experimental Ex. 19 | 63 | Transparent |
| Experimental Ex. 20 | 63 | Transparent |
| Experimental Ex. 21 | 65 | Transparent |
| Experimental Ex. 22 | 67 | Transparent |
| Experimental Ex. 23 | 66 | Transparent |
| Experimental Ex. 24 | 63 | Transparent |
| Experimental Ex. 25 | 67 | Transparent |
| Experimental Ex. 26 | 66 | Transparent |
| Experimental Ex. 27 | 65 | Transparent |
| Experimental Ex. 28 | 66 | Transparent |
| Experimental Ex. 29 | 63 | Transparent |
| Experimental Ex. 30 | 65 | Transparent |
| Experimental Ex. 31 | 66 | Transparent |
| Experimental Ex. 32 | 63 | Transparent |
| Experimental Ex. 33 | 62 | Transparent |
| Experimental Ex. 34 | 64 | Transparent |
| Experimental Ex. 35 | 62 | Transparent |
| Experimental Ex. 36 | 62 | Transparent |
| Experimental Ex. 37 | 64 | Transparent |
| Experimental Ex. 38 | 62 | Transparent |
| Experimental Ex. 39 | 63 | Transparent |
| Experimental Ex. 40 | 65 | Transparent |
| Experimental Ex. 41 | 64 | Transparent |
| Experimental Ex. 42 | 61 | Transparent |
| Experimental Ex. 43 | 63 | Transparent |
| Experimental Ex. 44 | 62 | Transparent |
| Experimental Ex. 45 | 60 | Transparent |
| Experimental Ex. 46 | 62 | Transparent |
| Experimental Ex. 47 | 61 | Transparent |
| Experimental Ex. 48 | 60 | Transparent |
| Experimental Ex. 49 | 62 | Transparent |
| Experimental Ex. 50 | 62 | Transparent |
| Experimental Ex. 51 | 65 | Transparent |
| Experimental Ex. 52 | 68 | Transparent |
| Experimental Ex. 53 | 67 | Transparent |
| Experimental Ex. 54 | 64 | Transparent |
| Experimental Ex. 55 | 68 | Transparent |
| Experimental Ex. 56 | 67 | Transparent |
| Experimental Ex. 57 | 66 | Transparent |
| Experimental Ex. 58 | 65 | Transparent |
| Experimental Ex. 59 | 67 | Transparent |
| Experimental Ex. 60 | 68 | Transparent |
| Experimental Ex. 61 | 66 | Transparent |
| Experimental Ex. 62 | 66 | Transparent |
| Experimental Ex. 63 | 67 | Transparent |
| Experimental Ex. 64 | 66 | Transparent |
| Experimental Ex. 65 | 64 | Transparent |
| Comparative Experimental Ex. 1 | 40 | Transparent |
| Comparative Experimental Ex. 2 | 55 | Transparent |
| Comparative Experimental Ex. 3 | 55 | Transparent |
| Comparative Experimental Ex. 4 | 54 | Transparent |
| Comparative Experimental Ex. 5 | 54 | Transparent |
| Comparative Experimental Ex. 6 | 54 | Transparent |
| Comparative Experimental Ex. 7 | 53 | Transparent |
| Comparative Experimental Ex. 8 | 53 | Transparent |
| Comparative Experimental Ex. 9 | 50 | Transparent |
| Comparative Experimental Ex. 10 | 50 | Transparent |
| Comparative Experimental Ex. 11 | 50 | Transparent |
| Comparative Experimental Ex. 12 | 58 | Transparent |
| Comparative Experimental Ex. 13 | 57 | Transparent |
| Comparative Experimental Ex. 14 | 57 | Transparent |
| Comparative Experimental Ex. 15 | 56 | Transparent |
| Comparative Experimental Ex. 16 | 55 | Transparent |
| Comparative Experimental Ex. 17 | 55 | Transparent |
| Comparative Experimental Ex. 18 | 54 | Transparent |
| Comparative Experimental Ex. 19 | 54 | Transparent |

On the basis of the results of the long-term research and the results of comparison among the measurements obtained by Experimental Examples 1 to 65 and Comparative Experimental Examples 1 to 19, it was determined that when the number of blocks with no pattern collapse was 60 or more among a total of 89 blocks, a good result was obtained.

In the cases of using the process solution compositions corresponding to Experimental Examples 1 to 65, it was confirmed that the pattern lifting defect level was lowered as compared to the cases of Comparative Experimental Examples 1 to 19, in which the process solution compositions corresponding to Experimental Examples 1 to 65 included: 0.00001% to 0.01% by weight of a fluorine-based surfactant selected from the group consisting of fluoroacryl carboxylate, fluoroalkyl ether, fluoroalkylene ether, fluoroalkyl sulfate, fluoroalkyl phosphate, fluoroacryl co-polymer, fluoro co-polymer, perfluorinated acid, perfluorinated carboxylate, perfluorinate sulfonate, and mixtures thereof; 0.00001% to 0.005% by weight of a pattern reinforcing agent represented by Formula (1) and selected from the group consisting of bis(1,1,2,2,3,3,3-heptafluoro-1-propanesulfonyl)imide, bis(1,1,2,2,3,3,4,4,4-nona Fluoro-1-butanesulfonyl)imide, 1,1,2,2,3,3-hexafluoropropane-1,3-disulfonylimide, bis(trifluoromethanesulfonyl)imide, and mixture thereof; 0.00001% to 0.01% by weight of a C3 to C10 triol derivative, a C4 to C14 tetraol derivative, or a combination thereof; and 99.97% to 99.99997% by weight of water, in which the C3 to C10 triol derivative is selected from the group consisting of 1,2,3-propanetriol, 1,2,4-butanetriol, 1,1,4-butanetriol, 1,3,5-pentanetriol, 1,2,5-pentanetriol, 2,3,4-pentanetriol, 1,2,3-hexanetriol, 1,2,6-hexanetriol, 1,3,4-hexanetriol, 1,4,5-hexanetriol, 2,3,4-hexanetriol, 1,2,3-heptanetriol, 1,2,4-heptanetriol, 1,2,6-heptanetriol, 1,3,5-heptanetriol, 1,4,7-heptanetriol, 2,3,4-heptanetriol, 2,4,6-heptanetriol, 1,2,8-octanetriol, 1,3,5-octanetriol, 1,4,7-octanetriol, butane-1,1,1-triol, 2-methyl-1,2,3-propanetriol, 5-methylhexane-1,2,3-triol, 2,6-dimethyl-3-heptene-2,4,6,-triol, benzene-1,3,5-triol, 2-methyl-benzene-1,2,3-triol, 5-methyl-benzene-1,2,3-triol, 2,4,6,-trimethylbenzene-1,3,5-triol, naphthalene-1,4,5-triol, 5,6,7,8-tetrahydro Naphthalene-1,6,7-triol, 5-hydromethylbenzene-1,2,3-triol, 5-isopropyl-2-methyl-5-cyclohexene-1,2,4-triol, 4-isopropyl-4-cyclohexene-1,2,3-triol, and mixtures thereof, and in which the C4 to C10 tetraol derivative is selected from the group consisting of 1,2,3,4-butanetetraol, 1,2,3,4-pentanetetraol, 1,2,4,5-pentanetetraol, 1,2,3,4-hexanetetraol, 1, 2,3,5-hexanetetraol, 1,2,3,6-hexanetetraol, 1,2,4,5-hexanetetraol, 1,2,4,6-hexanetetraol, 1,2,5,6-hexanetetraol, 1,3,4,5-hexanetetraol, 1,3,4,6-hexanetetraol, 2,3,4,5-hexanetetraol, 1,2,6,7-heptanetetraol, 2,3,4,5-heptanetetraol, 1,1,1,2-octanetetraol, 1,2,7,8-octanetetraol, 1,2,3,8-octanetetraol, 1,3,5,7-octanetetraol, 2,3,5,7-octanetetraol, 4,5,6,7-octanetetraol, 3,7-dimethel-3-octene-1,2,6,7-tetraol, 3-hexyne-1,2,5,6-tetraol, 2,5-dimethyl-3-hexyne-1,2,5,6-tetraol, anthracene- 1,4,9,10-tetraol, and mixtures thereof.

In addition, in the cases of using process solution compositions described below among the process solution compositions corresponding to Experimental Examples 1 to 65, it was confirmed that the pattern lifting defect level was favorably lowered as compared to the cases of Comparative Experimental Examples 1 to 19, in which the used process solution compositions included: 0.0001% to 0.01% by weight of a fluorine-based surfactant selected from the group consisting of fluoroacryl carboxylate, fluoroalkyl ether, fluoroalkylene ether, fluoroalkyl sulfate, fluoroalkyl phosphate, fluoroacryl co-polymer, fluoro co-polymer, perfluorinated acid, perfluorinated carboxylate, perfluorinate sulfonate, and mixtures thereof; 0.00001% to 0.005% by weight of a pattern reinforcing agent represented by Formula (1) and selected from the group consisting of bis(1,1,2,2,3,3,3-heptafluoro-1-propanesulfonyl)imide, bis(1,1,2,2,3,3,4,4,4-nonafluoro-1-butanesulfonyl)imide, 1,1,2,2,3,3-hexafluoropropane-1,3-disulfonylimide, bis(trifluoromethanesulfonyl)imide, and mixture thereof; 0.00001% to 0.01% by weight of a C3 to C10 triol derivative, a C4 to C14 tetraol derivative, or a combination thereof; and 99.97% to 99.99988% by weight of water, in which the C3 to C10 triol derivative is selected from the group consisting of 1,2,3-propanetriol, 1,2,4-butanetriol, 1,1,4-butanetriol, 1,3,5-pentanetriol, 1,2,5-pentanetriol, 2,3,4-pentanetriol, 1,2,3-hexanetriol, 1,2,6-hexanetriol, 1,3,4-hexanetriol, 1,4,5-hexanetriol, 2,3,4-hexanetriol, 1,2,3-heptanetriol, 1,2,4-heptanetriol, 1,2,6-heptanetriol, 1,3,5-heptanetriol, 1,4,7-heptanetriol, 2,3,4-heptanetriol, 2,4,6-heptanetriol, 1,2,8-octanetriol, 1,3,5-octanetriol, 1,4,7-octanetriol, butane-1,1,1-triol, 2-methyl-1,2,3-propanetriol, 5-methylhexane-1,2,3-triol, 2,6-dimethyl-3-heptene-2,4,6,-triol, benzene-1,3,5-triol, 2-methyl-benzene-1,2,3-triol, 5-methyl-benzene-1,2,3-triol, 2,4,6,-trimethylbenzene-1,3,5-triol, naphthalene-1,4,5-triol, 5,6,7,8-tetrahydronaphthalene-1,6,7-triol, 5-hydromethylbenzene-1,2,3-triol, 5-isopropyl-2-methyl-5-cyclohexene-1,2,4-triol, 4-isopropyl-4-cyclohexene-1,2,3-triol, and mixtures thereof, and in which the C4 to C10 tetraol derivative is selected from the group consisting of 1,2,3,4-butanetetraol, 1,2,3,4-pentanetetraol, 1,2,4,5-pentanetetraol, 1,2,3,4-hexanetetraol, 1,2,3,5-hexanetetraol, 1,2,3,6-hexanetetraol, 1,2,4,5-hexanetetraol, 1,2,4,6-hexanetetraol, 1,2,5,6-hexanetetraol, 1,3,4,5-hexanetetraol, 1,3,4,6-hexanetetraol, 2,3,4,5-hexanetetraol, 1,2,6,7-heptanetetraol, 2,3,4,5-heptanetetraol, 1,1,1,2-octanetetraol, 1,2,7,8-octanetetraol, 1,2,3,8-octanetetraol, 1,3,5,7-octanetetraol, 2,3,5,7-octanetetraol, 4,5,6,7-octanetetraol, 3,7-dimethel-3-octene-1,2,6,7-tetraol, 3-hexyne-1,2,5,6-tetraol, 2,5-dimethyl-3-hexyne-1,2,5,6-tetraol, anthracene- 1,4,9,10-tetraol, and mixtures thereof.

In addition, in the cases of using process solution compositions described below, among the process solution compositions corresponding to Experimental Examples 1 to 65, it was confirmed that the pattern lifting defect level was more favorably lowered as compared to the cases of Comparative Experimental Examples 1 to 19. The used process solution compositions included: 0.001% to 0.01% by weight of a fluorine-based surfactant selected from the group consisting of fluoroacryl carboxylate, fluoroalkyl ether, fluoroalkylene ether, fluoroalkyl sulfate, fluoroalkyl phosphate, fluoroacryl co-polymer, fluoro co-polymer, perfluorinated acid, perfluorinated carboxylate, perfluorinate sulfonate, and mixtures thereof; 0.00001% to 0.005% by weight of a pattern reinforcing agent represented by Formula (1) and selected from the group consisting of bis(1,1,2,2,3,3,3-heptafluoro-1-propanesulfonyl)imide, bis(1,1,2,2,3,3,4,4,4-nona Fluoro-1-butanesulfonyl)imide, 1,1,2,2,3,3-hexafluoropropane-1,3-disulfonylimide, bis(trifluoromethanesulfonyl)imide, and mixture thereof; 0.00001% to 0.01% by weight of a C3 to C10 triol derivative, a C4 to C14 tetraol derivative, or a combination thereof; and 99.97% to 99.99898% by weight of water, in which the C3 to C10 triol derivative is selected from the group consisting of 1,2,3-propanetriol, 1,2,4-butanetriol, 1,1,4-butanetriol, 1,3,5-pentanetriol, 1,2,5-pentanetriol, 2,3,4-pentanetriol, 1,2,3-hexanetriol, 1,2,6-hexanetriol, 1,3,4-hexanetriol, 1,4,5-hexanetriol, 2,3,4-hexanetriol, 1,2,3-heptanetriol, 1,2,4-heptanetriol, 1,2,6-heptanetriol, 1,3,5-heptanetriol, 1,4,7-heptanetriol, 2,3,4-heptanetriol, 2,4,6-heptanetriol, 1,2,8-octanetriol, 1,3,5-octanetriol, 1,4,7-octanetriol, butane-1,1,1-triol, 2-methyl-1,2,3-propanetriol, 5-methylhexane-1,2,3-triol, 2,6-dimethyl-3-heptene-2,4,6,-triol, benzene-1,3,5-triol, 2-methyl-benzene-1,2,3-triol, 5-methyl-benzene-1,2,3-triol, 2,4,6,-trimethylbenzene-1,3,5-triol, naphthalene-1,4,5-triol, 5,6,7,8-tetrahydro Naphthalene-1,6,7-triol, 5-hydromethylbenzene-1,2,3-triol, 5-isopropyl-2-methyl-5-cyclohexene-1,2,4-triol, 4-isopropyl-4-cyclohexene-1,2,3-triol, and mixtures thereof, and in which the C4 to C10 tetraol derivative is selected from the group consisting of 1,2,3,4-butanetetraol, 1,2,3,4-pentanetetraol, 1,2,4,5-pentanetetraol, 1,2,3,4-hexanetetraol, 1,2,3,5-hexanetetraol, 1,2,3,6-hexanetetraol, 1,2,4,5-hexanetetraol, 1,2,4,6-hexanetetraol, 1,2,5,6-hexanetetraol, 1,3,4,5-hexanetetraol, 1,3,4,6-hexanetetraol, 2,3,4,5-hexanetetraol, 1,2,6,7-heptanetetraol, 2,3,4,5-heptanetetraol, 1,1,1,2-octanetetraol, 1,2,7,8-octanetetraol, 1,2,3,8-octanetetraol, 1,3,5,7-octanetetraol, 2,3,5,7-octanetetraol, 4,5,6,7-octanetetraol, 3,7-dimethel-3-octene - 1,2,6,7-tetraol, 3-hexyne-1,2,5,6-tetraol, 2,5-dimethyl-3-hexyne-1,2,5,6-tetraol, anthracene- 1,4,9,10-tetraol, and mixtures thereof.

In addition, in the cases of using process solution compositions described below, among the process solution compositions corresponding to Experimental Examples 1 to 65, it was confirmed that the pattern lifting defect level was more favorably lowered as compared to the cases of Comparative Experimental Examples 1 to 19, in which the used process solution compositions included: 0.001% to 0.01% by weight of a fluorine-based surfactant selected from the group consisting of fluoroacryl carboxylate, fluoroalkyl ether, fluoroalkylene ether, fluoroalkyl sulfate, fluoroalkyl phosphate, fluoroacryl co-polymer, fluoro co-polymer, perfluorinated acid, perfluorinated carboxylate, perfluorinate sulfonate, and mixtures thereof; 0.0001% to 0.005% by weight of a pattern reinforcing agent represented by Formula (1) and selected from the group consisting of bis(1,1,2,2,3,3,3-heptafluoro-1-propanesulfonyl)imide, bis(1,1,2,2,3,3,4,4,4-nonafluoro-1-butanesulfonyl)imide, 1,1,2,2,3,3-hexafluoropropane-1,3-disulfonylimide, bis(trifluoromethanesulfonyl)imide, and mixture thereof; 0.00001% to 0.01% by weight of a C3 to C10 triol derivative, a C4 to C14 tetraol derivative, or a combination thereof; and 99.97% to 99.99889% by weight of water, in which the C3 to C10 triol derivative is selected from the group consisting of 1,2,3-propanetriol, 1,2,4-butanetriol, 1,1,4-butanetriol, 1,3,5-pentanetriol, 1,2,5-pentanetriol, 2,3,4-pentanetriol, 1,2,3-hexanetriol, 1,2,6-hexanetriol, 1,3,4-hexanetriol, 1,4,5-hexanetriol, 2,3,4-hexanetriol, 1,2,3-heptanetriol, 1,2,4-heptanetriol, 1,2,6-heptanetriol, 1,3,5-heptanetriol, 1,4,7-heptanetriol, 2,3,4-heptanetriol, 2,4,6-heptanetriol, 1,2,8-octanetriol, 1,3,5-octanetriol, 1,4,7-octanetriol, butane-1,1,1-triol, 2-methyl-1,2,3-propanetriol, 5-methylhexane-1,2,3-triol, 2,6-dimethyl-3-heptene-2,4,6,-triol, benzene-1,3,5-triol, 2-methyl-benzene-1,2,3-triol, 5-methyl-benzene-1,2,3-triol, 2,4,6,-trimethylbenzene-1,3,5-triol, naphthalene-1,4,5-triol, 5,6,7,8-tetrahydro Naphthalene-1,6,7-triol, 5-hydromethylbenzene-1,2,3-triol, 5-isopropyl-2-methyl-5-cyclohexene-1,2,4-triol, 4-isopropyl-4-cyclohexene-1,2,3-triol, and mixtures thereof, and in which the C4 to C10 tetraol derivative is selected from the group consisting of 1,2,3,4-butanetetraol, 1,2,3,4-pentanetetraol, 1,2,4,5-pentanetetraol, 1,2,3,4-hexanetetraol, 1, 2,3,5-hexanetetraol, 1,2,3,6-hexanetetraol, 1,2,4,5-hexanetetraol, 1,2,4,6-hexanetetraol, 1,2,5,6-hexanetetraol, 1,3,4,5-hexanetetraol, 1,3,4,6-hexanetetraol, 2,3,4,5-hexanetetraol, 1,2,6,7-heptanetetraol, 2,3,4,5-heptanetetraol, 1,1,1,2-octanetetraol, 1,2,7,8-octanetetraol, 1,2,3,8-octanetetraol, 1,3,5,7-octanetetraol, 2,3,5,7-octanetetraol, 4,5,6,7-octanetetraol, 3,7-dimethel-3-octene - 1,2,6,7-tetraol, 3-hexyne-1,2,5,6-tetraol, 2,5-dimethyl-3-hexyne-1,2,5,6-tetraol, anthracene- 1,4,9,10-tetraol, and mixtures thereof.

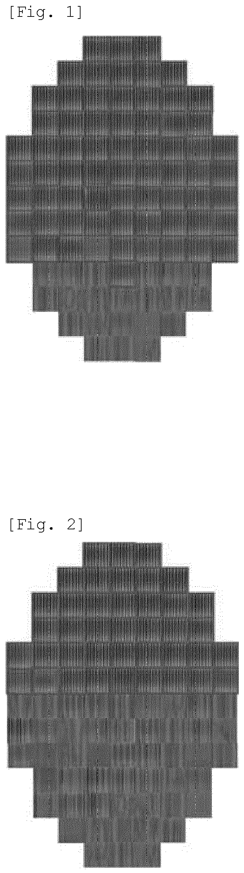

As shown in FIG. 1, the result of determining the collapse level of the photoresist pattern formed according to Example 1 was that the number of blocks in which the pattern collapse did not occur was 68. That is, the composition of Example 1 exhibited the best effect.

As shown in FIG. 2, the result of determining the collapse level of the photoresist pattern according to Comparative Experimental Example 1 was that the number of blocks in which the pattern collapse did not occur was 40.

The specific aspects of the present disclosure are described in detail above. It would be apparent to a person of ordinary skill in the art to which the present disclosure pertains that this specific description is only for the desired embodiments and do not impose any limitation on the scope of the present disclosure. Therefore, a substantial scope and a scope equivalent thereto must be defined by the following claims.

## Claims

1. A process solution composition for EUV photolithography, the composition comprising:
0.00001% to 0.01% by weight of a fluorine-based surfactant;
0.00001% to less than 0.01% by weight of a pattern reinforcing agent that is selected from chemical compounds represented by Formula (1) and mixtures of the compounds;
0.00001% to 0.01% by weight of a material selected from the group consisting of triol derivatives, tetraol derivatives, and mixtures thereof; and
the balance being water, 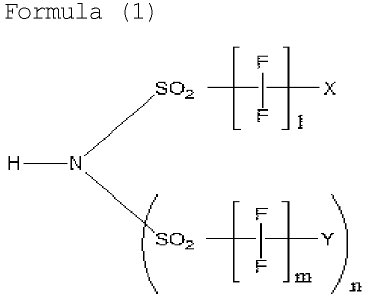
in Formula (1) above, X and Y are fluorine or C1-C5 alkyl, X and Y form a single bond, l is within a range of 1 to 5, m is within a range of 0 to 5, and n is within a range of 0 to 2.

2. The process solution composition for EUV photolithography, according to claim 1, the composition comprising:
0.00001% to 0.01% by weight of a fluorine-based surfactant;
0.00001% to 0.005% by weight of a pattern reinforcing agent that is selected from chemical compounds represented by Formula (1) and mixtures of the compounds;
0.00001% to 0.01% by weight of a material selected from the group consisting of triol derivatives, tetraol derivatives, and mixtures thereof; and
the balance being water.

3. The composition of claim 1, wherein the fluorine-based surfactant is selected from the group consisting of fluoroacryl carboxylate, fluoroalkyl ether, fluoroalkylene ether, fluoroalkyl sulfate, fluoroalkyl phosphate, fluoroacryl copolymer, fluoro co-polymer, perfluorinated acid, perfluorinated carboxylate, perfluorianted sulfonate, and mixtures thereof.

4. The composition of claim 1, wherein the pattern reinforcing agent that is one of chemical compounds represented by Formula (1) or a mixture thereof is any one selected from the group consisting of bis(1,1,2,2,3,3,3-heptafluoro-1-propanesulfonyl)imide, bis(1,1,2 ,2,3,3,4,4,4-nonafluoro-1-butanesulfonyl)imide, 1,1,2,2,3,3-hexafluoropropane-1,3-disulfonyimide, bis(trifluoromethanesulfonyl)imide, and mixtures thereof.

5. The composition of claim 1, wherein the triol derivative is a C3 to C10 triol derivative selected from the group consisting of 1,2,3-propanetriol, 1,2,4-butanetriol, 1,1,4-butanetriol, 1,3,5-pentanetriol, 1,2,5-pentanetriol, 2,3,4-pentanetriol, 1,2,3-hexanetriol, 1,2,6-hexanetriol, 1,3,4-hexanetriol, 1,4,5-hexanetriol, 2,3,4-hexanetriol, 1,2,3-heptanetriol, 1,2,4-heptanetriol, 1,2,6-heptanetriol, 1,3,5-heptanetriol, 1,4,7-heptanetriol, 2,3,4-heptanetriol, 2,4,6-heptanetriol, 1,2,8-octanetriol, 1,3,5-octanetriol, 1,4,7-octanetriol, butane-1,1,1-triol, 2-methyl-1,2,3-propanetriol, 5-methylhexane-1,2,3-triol, 2,6-dimethyl-3-heptene-2,4,6,-triol, benzene-1,3,5-triol, 2-methyl-benzene-1,2,3-triol, 5-methyl-benzene-1,2,3-triol, 2,4,6,-trimethylbenzene-1,3,5-triol, naphthalene-1,4,5-triol, 5,6,7,8-tetrahydro Naphthalene-1,6,7-triol, 5-hydromethylbenzene-1,2,3-triol, 5-isopropyl-2-methyl-5-cyclohexene-1,2,4-triol, 4-isopropyl-4-cyclohexene-1,2,3-triol, and mixtures thereof, and
wherein the tetraol derivative is a C4 to C14 tetraol derivative selected from the group consisting of 1,2,3,4-butanetetraol, 1,2,3,4-pentanetetraol, 1,2,4,5-pentanetetraol, 1,2,3,4-hexanetetraol, 1,2,3,5-hexanetetraol, 1,2,3,6-hexanetetraol, 1,2,4,5-hexanetetraol, 1,2,4,6-hexanetetraol, 1,2,5,6-hexanetetraol, 1,3,4,5-hexanetetraol, 1,3,4,6-hexanetetraol, 2,3,4,5-hexanetetraol, 1,2,6,7-heptanetetraol, 2,3,4,5-heptanetetraol, 1,1,1,2-octanetetraol, 1,2,7,8-octanetetraol, 1,2,3,8-octanetetraol, 1,3,5,7-octanetetraol, 2,3,5,7-octanetetraol, 4,5,6,7-octanetetraol, 3,7-dimethel-3-octene-1,2,6,7-tetraol, 3-hexyne-1,2,5,6-tetraol, 2,5-dimethyl-3-hexyne-1,2,5,6-tetraol, anthracene-1,4,9,10-tetraol, and mixtures thereof.

6. A method of forming a photoresist pattern, the method comprising:
(a) forming a photoresist film on a semiconductor substrate by applying a photoresist to the semiconductor substrate;
(b) forming a photoresist pattern by exposing and developing the photoresist film; and
(c) cleaning the photoresist pattern with the process solution composition of any one of claims 1 and 3 to 5.
